# EUROPEAN PATENT APPLICATION

(11) **EP 2 053 647 A2**
(43) Date of publication of application: **29.04.2009**
(21) Application number: 08253453.8
(22) Date of filing: 23.10.2008
(51) Int. Cl.: H01L 21/60, H01L 21/48

(54) **Semiconductor chip mounting method, semiconductor mounting wiring board producing method and semiconductor mounting wiring board**

(30) Priority: 24.10.2007 JP 2007276578
(71) Applicant: Omron Corporation, Kyoto-shi, Kyoto 600-8530 (JP)
(72) Inventor: Yoshida, Kazutaka, Kyoto-shi, Kyoto 600-8530 (JP); Kawai, Wakahiro, Kyoto-shi, Kyoto 600-8530 (JP)
(74) Representative: Calderbank, Thomas Roger

(57) **Abstract**

A method of producing a wiring board on which a semiconductor chip is to be mounted, includes: adhering an aluminum foil to one surface of a resin substrate; providing a heat-hardening resin layer having a predetermined shape on the aluminum foil; removing a part of the aluminum foil which is exposed from the heat-hardening resin layer to form a wiring circuit; and providing a thermoplastic resin layer on the wiring circuit. The heat-hardening resin layer has strength that enables the wiring board to prevent short between the semiconductor chip and the wiring circuit and has a crosslinking degree that is so reduced as to enable the bump to remove the heat-hardening resin layer to reach the wiring circuit, when the heat is applied to the wiring board and the bump to which the ultrasonic wave is applied is pressed to the wiring board.

## Description

This invention relates to a semiconductor chip mounting method that is suitably employed for production of a data carrier capable of reading electromagnetic wave and functioning as an air cargo management tag, a physical distribution management label, an unattended ticket gate, and the like as well as to a semiconductor mounting wiring board producing method and a semiconductor mounting wiring board and, particularly, to a semiconductor chip mounting method, a semiconductor mounting wiring board producing method and a semiconductor mounting wiring board that enable a semiconductor chip to be mounted on a wiring board by employing a flip-chip method, by utilizing an ultrasonic wave, and at a low cost.

In recent years, along with progresses in card type electronic appliance, physical distribution management tag, portable electronic appliance such as mobile phone, image appliances, or the like, there is a rapidly increasing demand for reductions in cost and thickness of a printed wiring board on which a semiconductor or the like are mounted.

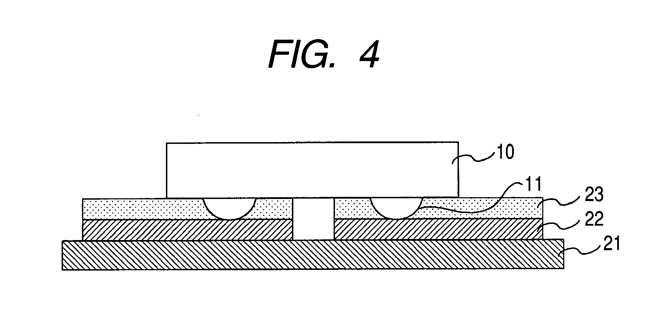

For the recent demand for thickness reduction mentioned above, proposals relating to a flip-chip method (hereinafter referred to as FC method) for directly mounting a bare semiconductor chip on a printed wiring board have actively been presented. Shown in Fig. 4 is a sectional view showing a mounting structure according to the semiconductor chip mounting method employing the FC method.

As shown in Fig. 4, in the FC method, projected terminals (hereinafter referred to as bump) 11 that has previously been formed on an electrode of a semiconductor chip 10 is aligned with a wiring circuit 22 on a resin substrate 21, followed by welding or connection using an electroconductive paste or the like.

However, in such related-art method, there is a problem that the welding step or the electroconductive paste supplying and hardening step for connecting the bump 11 and the wiring circuit 22 is complicated and entails an increased cost, and, since it is necessary to seal a bump connection part by filling an insulation resin called an underfill resin 23 between the semiconductor chip 10 and the resin substrate 21 in order to secure humidity resistance reliability of the bump connection part or to achieve semiconductor mounting strength, there is a problem that a production cost is increased due to the necessity of a process step for filling and hardening the underfill resin 23.

As a solution to the problems, a method of mounting a semiconductor by using an anisotropically conductive film (hereinafter referred to as ACF) is known as proposed by Japanese Patent No. 2586154. In this related-art method, an ACF obtained by dispersing fine electroconductive particles into a thermoplastic or heat-hardening resin is inserted between a semiconductor and a substrate circuit, and the resin is fluidized by thermocompression bonding, thereby establishing electrical connection in a thickness direction by the electroconductive fine particles sandwiched between a bump and the substrate circuit. This method enables to relatively roughly perform the alignment with the substrate circuit when mounting the semiconductor and has the effects of shortening the resin hardening time to 10 to 20 seconds and eliminating the necessity of using a sealant such as the underfill resin.

However, the anisotropically conductive sheet is relatively expensive and has a drawback of not usable on a substrate that is not heat resistant since the anisotropically conductive sheet requires a high temperature of 200°C or more as a hardening temperature. Also, though the anisotropically conductive sheet requires a relatively short time for hardening a resin material, which is 10 to 20 seconds, it is difficult to further simplify or speed up the process step.

Further, since the electrical connection between the bump and the substrate pattern is performed by way of contact by fine electroconductive particles dispersed into the resin material, there is a problem that the connection has poor reliability.

Accordingly, another semiconductor chip mounting method has been proposed as disclosed in JP-A-2001-156110. The related-art mounting method will be explained below.

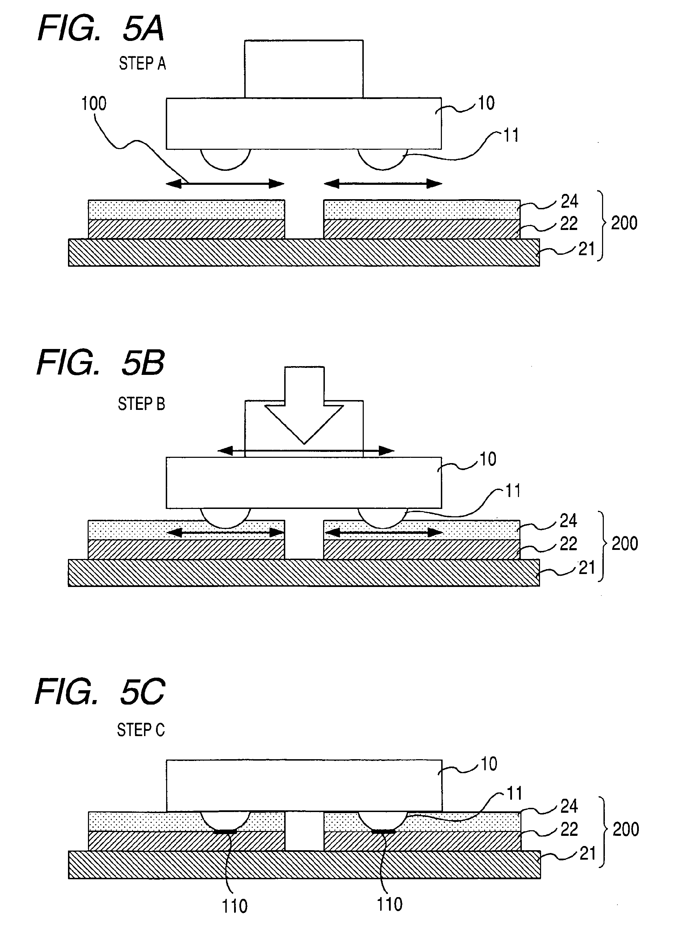

Figs. 5A to 5C are diagrams illustrating details of an ultrasonic wave mounting steps, and, in the semiconductor chip mounting method: a semiconductor mounting wiring board 200 formed by applying an ink material made from a thermoplastic resin material (resist) 24 in the form of a predetermined wiring circuit 22 on a surface of a metal foil laminated on a resin substrate 21 and removing the metal exposed from the ink material by etching is heated (step A); subsequently, the thermoplastic resin layer 24 is removed by pressing a bump 11 projected from a semiconductor chip 10 to the semiconductor mounting wiring board 200 while applying an ultrasonic wave 100 (step B) ; and an electrode region 110 is formed by the ultrasonic wave 100 between the bump 11 and a wiring circuit 22 (step C).

It is possible to perform the production process, the ultrasonic wave bonding, and the melting and hardening of thermoplastic resin within 1 to 2 seconds by using the related-art method disclosed in JP-A-2001-156110 to shorten the production time. The fused metal bonding between the bump and the wiring' circuit by the ultrasonic oscillation enables reliable inter-terminal connection, thereby achieving improved reliability of the connection.

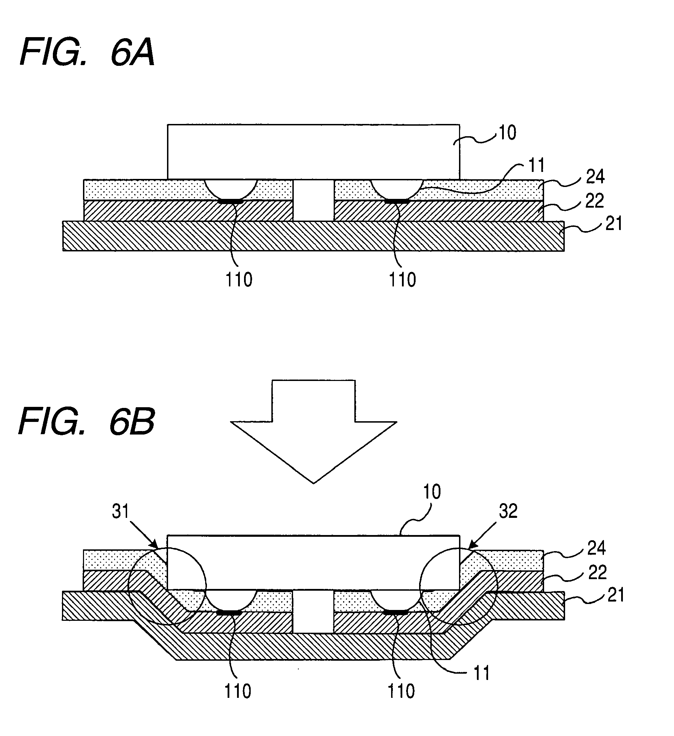

However, as shown in Figs. 6A and 6B, since electrical insulation between a part directly under the semiconductor chip 10 and the wiring circuit 22 is provided only by the thermoplastic resin layer 24, it is possible that the part directly under the semiconductor chip 10 and the wiring circuit 22 are brought into electrical short due to re-softening and fluidization of the thermoplastic resin layer 24 when a high temperature and a high pressure are simultaneously applied to the mounting part of the semiconductor chip 10 during the lamination press, the injection molding and the like employed in manufacture of a card or the like (see sections indicated by reference numerals 31 and 32 of Fig. 6B).

It is therefore a preferred aim of the invention to provide a semiconductor chip mounting method, a semiconductor mounting wiring board producing method and a semiconductor mounting wiring board, in which electrical short between a,part directly under a semiconductor and a wiring pattern may be prevented in the case where a high temperature and a high pressure are applied to a semiconductor mounting part.

A according to the invention, there is provided a method of producing a wiring board on which a semiconductor chip is to be mounted, the method comprising:
adhering an aluminum foil to one surface of a resin substrate;
providing a heat-hardening resin layer having a predetermined shape on the aluminum foil;
removing a part of the aluminum foil which is exposed from the heat-hardening resin layer to form a wiring circuit; and
providing a thermoplastic resin layer on the wiring circuit.

According to the invention, there is provided a method of mounting the semiconductor chip on the wiring board, comprising:
applying heat to the wiring board;
pressing a bump of the semiconductor chip to the thermoplastic resin layer which is softened by the heat, while applying an ultrasonic wave to the bump;
causing the bump to be in contact with the wiring circuit;
applying the ultrasonic wave to the bump in a state where the bump and the wiring circuit are in contact with each other; and
adhering the semiconductor bear chip to the wiring board by cool-solidifying the thermoplastic resin layer,
wherein the heat-hardening resin layer has strength that enables the wiring board to prevent short between the semiconductor chip and the wiring circuit and has a crosslinking degree that is so reduced as to enable the bump to remove the heat-hardening resin layer to reach the wiring circuit, when the heat is applied to the wiring board and the bump to which the ultrasonic wave is applied is pressed to the wiring board.

According to the invention, there is also provided a wiring board on which a semiconductor chip is to be mounted, the wiring board comprising:
a resin substrate;
a wiring circuit provided on one surface of the resin substrate;
a heat-hardening resin layer provided on the wiring circuit; and
a thermoplastic resin layer provided on the heat-hardening resin layer.

The heat-hardening resin layer may have strength that enables the wiring board to prevent short between the semiconductor chip and the wiring circuit and has a crosslinking degree that is so reduced as to enable a bump of the semiconductor chip to remove the heat-hardening resin layer to reach the wiring circuit, when heat is applied to the wiring board and the bump to which an ultrasonic wave is applied is pressed to the wiring board.

The heat-hardening resin layer may include an epoxy-based resin to which a hardening agent such as amines, acid anhydrides and phenols, and a hardening catalyst such as amines.

As used herein, the heat-hardening resin means a polymer material having a steric lattice structure, which is hardened as forming a three-dimensional bridging bond (crosslink) between molecules when a powder or a liquid called prepolymer having a small polymerization degree or a substance obtained by adding a substance such as hardening agent to the prepolymer is heated. Due to the three-dimensional crosslink structure, physical properties such as heat resistance and chemical resistance are superior to thermoplastic resins. Examples of representative heat-hardening resins include a phenol resin, an epoxy-based resin, a urea resin, a melamine resin, an unsaturated polyester resin, polyurethane, polyimide, and the like.

Among the heat-hardening resins, the epoxy resin is used for electronic parts (for sealing printed wiring board, resistor, and condenser), semiconductor sealing (for sealing transistor, IC, LSI, COB, PPGA, TAB, etc.), and the urea resin is used for wiring/illumination parts, wiring tool parts, control parts, sliding parts, convenience goods, caps, and the like, for example. Thus, each of the heat-hardening resins has suitable use and unsuitable use.

Also, the contents and the hardening method are varied depending on the type of the heat-hardening resin. For instance, the epoxy resin is the resin having an epoxy group obtainable by condensation or the like of bisphenol A and epichlorohydrin and classified into glycidyl type and non-glycidyl type and forms a three-dimensional structure when hardened by a reaction with a hardening agent.

In this invention, a degree of crosslinking is reduced by reducing an amount of the hardening agent to be contained in the heat-hardening resin from a related-art amount. As used herein, the term "related-art amount" is a degree with which the part directly under the semiconductor chip and the wiring circuit are not brought into electrical short and a rigid heat-hardening resin layer that is not in the softened state remains on the surface of the wiring circuit to prevent inhibition of the formation of the electrode region between the bump and the wiring circuit.

The property of the epoxy-based resin as an adhesive agent is represented by its hardening degree, and it is possible to estimate the hardening degree of an organic polymer by a crosslinking degree of molecules. Therefore, in the case of using the epoxy-based resin as the heat-hardening resin, the hardening degree is reduced by reducing the amount of the hardening agent from the related-art amount, preferably to a half of the related-art amount, in order to suppress the crosslinking degree thereby making it possible to easily peel off the epoxy as well as to facilitate metal bonding between the bump of the semiconductor chip and Al of the substrate. In the drawings: ,

Fig. 1 is a sectional view showing a mounting structure of a semiconductor chip in the invention.

Figs. 2A, 2B, 2C and 2D are diagrams illustrating production steps of the semiconductor mounting wiring board according to the invention.

Fig. 3 is a diagram showing results of comparison of shear strengths between a related-art heat-hardening resin and a heat-hardening resin of the invention.

Fig. 4 is a sectional view showing a mounting structure according to a related-art mounting method.

Figs. 5A, 5B and 5C are diagrams illustrating details of a related-art ultrasonic mounting step.

Figs. 6A and 6B are diagrams illustrating problems according to the related-art mounting method.

Hereinafter, embodiments of this invention will be described based on the accompanying drawings.

A structure of a semiconductor mounting wiring board of this invention is substantially the same as that of a wiring board shown in Fig. 6A, and the difference is a heat-hardening resin layer 40 provided between a wiring circuit 22 and a thermoplastic resin layer 24. Therefore, the structure identical with the semiconductor mounting wiring board 200 shown in Fig. 6A is denoted by the same reference numeral, and detailed description thereof is omitted.

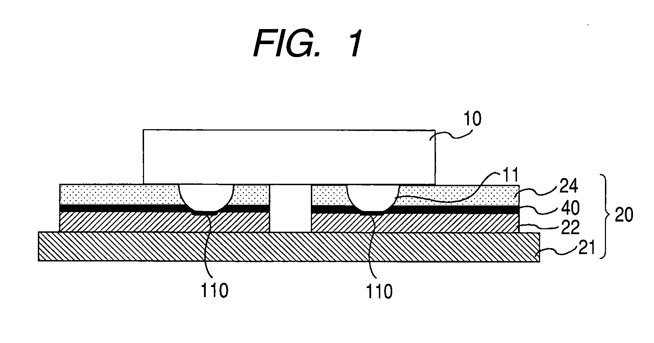

As shown in Fig. 1, a semiconductor mounting wiring board 20 according to this invention is formed of two functional layers of the heat-hardening resin layer 40 serving as a resist film for etching processing and the thermoplastic resin layer 24 obtained by lamination on a surface of the heat-hardening resin layer 40, which are formed on a surface of a wiring circuit 22 laminated on a resin substrate 21. The heat-hardening resin layer 40 includes a resin obtained by adding a hardening agent (e.g. amines, acid anhydrides, phenols, etc.) in an amount that is a half of a related-art amount to an epoxy-based material or a resin obtained by reducing, in the above-mentioned resin, an amount of a hardening catalyst (e.g. amines) to a half of a related-art amount.

The epoxy-based heat-hardening resin is generally used for electronic parts (for sealing print wiring board, resistor/condenser), for sealing semiconductors (for sealing transistor, IC, LSI, COB, PPGA, TAB), and the like, and, as used herein, the term "half of related-art amount" means an amount that is a half of a general use amount of a hardening agent contained in each of the above usages.

In the semiconductor mounting wiring board 20 according to this invention, the heat-hardening resin layer 40 is provided on a boundary surface between the thermoplastic resin layer 24 and the wiring circuit 22 of the semiconductor mounting wiring board 20. With such constitution, it is possible to achieve an effect of preventing the problem of electrical short between a part directly under the semiconductor chip 10 and the wiring circuit 22 as shown in Fig. 6B in the case where a high temperature and a high pressure are simultaneously applied to a mounting part of the semiconductor chip 10 during processing of lamination press, injection molding, and the like that are employed in manufacture of a card or the like.

In the case where a heat-hardening resin to be used for the heat-hardening resin layer 40 is a related-art type, i.e. is the one containing the hardening agent in an amount required for satisfying an ordinary quality demand to be used for electronic parts (for sealing print wiring board, resistor/condenser), for sealing semiconductors (for sealing transistor, IC, LSI, COB, PPGA, TAB), and the like, the following problem can occur in the case where the mounting method proposed in JP-A-2001-156110 is employed. That is, in a state where an ultrasonic wave 100 is applied to the semiconductor chip 10 of step B in Fig. 5B in the step of removing the thermoplastic resin layer 24 and the heat-hardening resin layer 40 serving as the two functional layers from a surface of the wiring circuit 22 by pressing a bump 11 projecting from the semiconductor chip 10 to the semiconductor mounting wiring board 200, the rigid heat-hardening resin layer 40 that is not in the softened state remains on the surface of the wiring circuit 22, thereby raising a problem of inhibiting formation of an electrode region 110 between the bump 11 and the wiring circuit 22.

Therefore, the inventors conducted an extensive research to find by an experiment that the remaining of the heat-hardening resin layer 40 on the wiring circuit 22 is primarily caused by its high crosslinking degree and rigidity and, based on the determined cause, devised a countermeasure of reducing the crosslinking degree by reducing the hardening agent to an amount that is a half of a related-art amount in an epoxy-based material forming the heat-hardening resin layer 40 or by further reducing the hardening catalyst to an amount that is a half of a related-art amount. With such constitution, it is possible to thoroughly remove the heat-hardening resin layer 40 while preventing the short as well as to achieve an effect of preventing inhibition of formation of the electrode region 110 between the bump 11 and the wiring circuit 22.

Hereinafter, one example according to this invention will be described in accordance with the drawings.

### <Example>

As described in the foregoing, a semiconductor chip mounting method according to the invention is a process including: providing, on the wiring circuit 22 formed on the resin substrate 21, insulating particles for the heat-hardening resin layer 40 that is reduced in crosslinking degree by reducing the hardening agent to an amount that is a half of a related-art amount in an epoxy-based material or further reducing the hardening catalyst to an amount that is a half of a related-art amount; removing the thermoplastic resin layer 24 and the heat-hardening resin layer 40 serving as insulating films on the wiring circuit 22 from the semiconductor mounting wiring board 20 obtained by covering a surface of the heat-hardening resin layer 40 with the thermoplastic resin layer 24 by pressing the bump 11 projecting from the semiconductor chip 10 to a surface of the thermoplastic resin layer 24 in a state where the thermoplastic resin layer is softened by heating while applying the ultrasonic wave 100 to the bump 11; and forming the electrode region 110 between the bump 11 and the wiring circuit 22.

The semiconductor mounting wiring board 20 of this example has a structure that the wiring circuit 22 made from a hard aluminum of 35 µm is formed on one surface of a PET (polyethylene telephthalate) film (resin substrate 21) of 25 µm, and the polyolefin-based thermoplastic resin layer 24 having a re-softened temperature of 90°C to 100°C is formed on the epoxy-based heat-hardening resin layer 40 obtained by adding thereto the hardening agent and the hardening catalyst and formed on the wiring circuit.

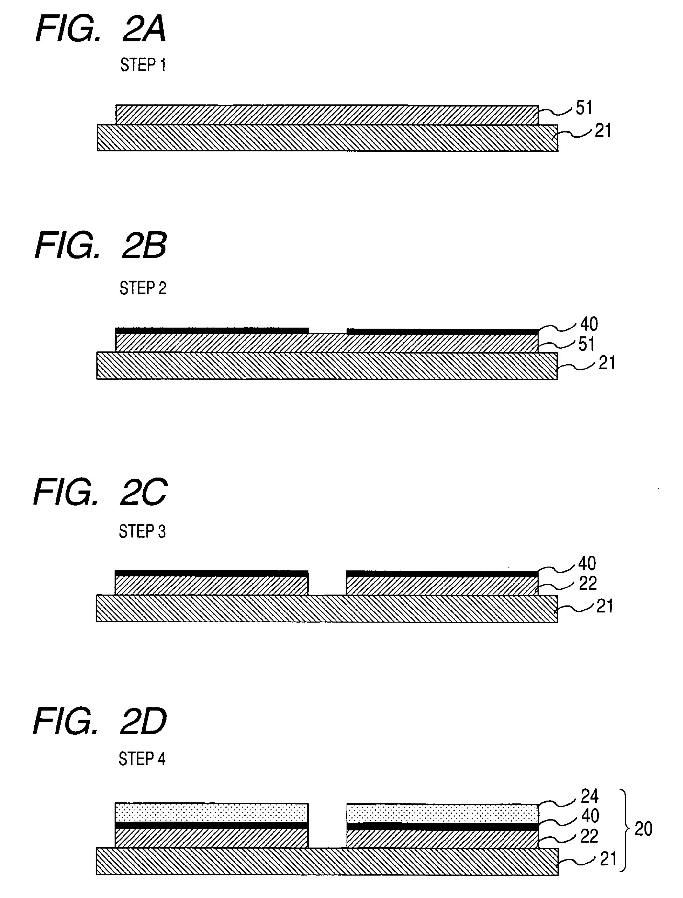

Hereinafter, steps for manufacturing the semiconductor mounting wiring board of this example will be described in accordance with Figs. 2A to 2D.

(Step 1) As a first step, an Al-PET laminated base material is prepared. As one example thereof, a hard aluminum foil 51 having a thickness of 35 µm is overlapped on one surface of a PET film (resin substrate 21) having a thickness of 25 µm via an urethane-based adhesive agent, followed by lamination bonding by heat lamination under the conditions of 150°C and a pressure of 5 kg/cm². Thus, the Al-PET laminated material in which the hard aluminum foil 51 is adhered to the surface of the PET film is completed.

(Step 2) Next, the epoxy-based heat-hardening resin layer 40 having a predetermined wiring pattern is formed on a surface of the hard aluminum foil 51 of the laminated material.

The heat-hardening resin layer 40 having a thickness of about 4 to 6 µm is formed by a method such as gravure printing or the like by applying on the Al-PET laminated material an ink obtained by mixing and dispersing the epoxy resin, the hardening agent, and the hardening catalyst in a solvent containing 30% of toluene, 6.1% of methylethylketone, and 12% of butylcellosolve, followed by drying at 130°C to 200°C for about 20 seconds to 1 minute. As the ink, an ink obtained by mixing and dispersing the epoxy resin and the hardening agent in the solvent containing 30% of toluene, 6.1% of methylethylketone, and 12% of butylcellosolve may be used.

By printing the heat-hardening resin layer 40 in the predetermined wiring pattern, it is possible to obtain an etching resist for the subsequent wiring circuit formation steps.

(Step 3) An Al foil part exposed from the etching resist formed by the above-described step is removed by performing etching processing to form the wiring circuit 22. That is, in this etching processing, NaOH (120 g/l) is used as an etching liquid under the condition of 50°C to remove the unnecessary Al.

(step 4) Finally, a polyolefin-based thermoplastic adhesive agent or the like that is molten at a temperature of about 90°C to 100°C is applied on a surface of the wiring circuit 22 (on the heat-hardening resin layer 40) by a thickness of about 4 to 6 µm by a method such as a gravure printing or the like to complete the semiconductor mounting wiring board 20 to be used in this invention.

Hereinafter, steps for mounting the semiconductor chip 10 on the semiconductor mounting wiring board 20 obtained by the above-described steps will be described.

(Step 11) The semiconductor chip 10 is formed as a so-called surface mounting type part having a metal terminal (bump) 11 for connection projected from a bottom surface thereof, and, in a state where ultrasonic oscillation of 63 KHz is applied to the bump 11 (made from gold, for example) projecting from the bottom part, the semiconductor chip 10 is pressed to the thermoplastic resin layer 24 that is softened by heating to 150°C at a pressure under load of 0.2 Kg/mm².

(Step 12) The thermoplastic resin layer 24 that is softened is easily removed from the position at the tip of the bump 11 by the ultrasonic oscillation 100 of the bump 11, so that the bump 11 reaches to the surface of the heat-hardening resin layer 40.

(Step 13) By further pressing the bump to the heat-hardening resin layer 40 while loading the ultrasonic oscillation to the bump, the heat-hardening resin layer 40 is removed by the tip of the bump 11, and the bump reaches to the surface of the wiring circuit 22.

An insulating layer such as an oxide layer existing on the surface of the wiring circuit 22 is removed mechanically by the ultrasonic oscillation to bring the metals (bump 11 and wiring circuit 22) into contact with each other. The metals are fused by frictional heat caused by the ultrasonic oscillation applied thereto in this state, thereby forming the electrode region 110.

An ultrasonic oscillation loading time in this mounting method is about 0.5 second, thereby enabling to mount the semiconductor chip in the considerably short time.

Further, after the above-described steps, when the heat of 150°C applied to the semiconductor mounting wiring board 20 is eliminated, the molten thermoplastic resin layer 24 is re-hardened so that the semiconductor chip 10 and the wiring circuit 22 are strongly adhered to each other.

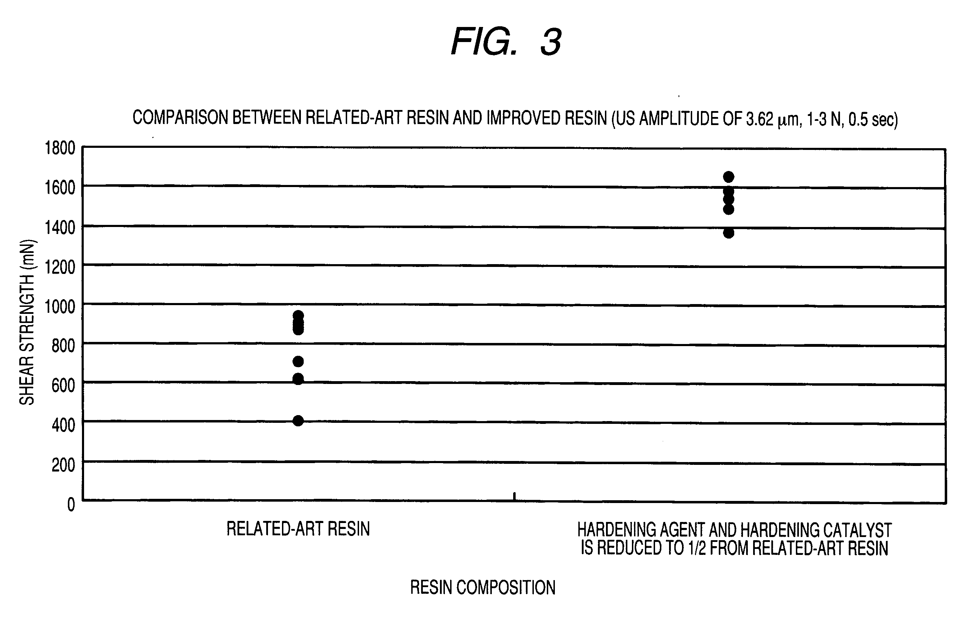

In order to investigate a bonding strength between the bump 11 and the semiconductor circuit 22 of the semiconductor chip 10 in this example, a semiconductor mounting wiring board 20 in which the thermoplastic resin layer 24 serving as the adhesive agent is not formed was prepared, and results obtained by comparing shear strengths after the mounting step by changing a material of the heat-hardening resin layer 40 to be used are shown in Fig. 3. As shown in Fig. 3, the epoxy layer in which the hardening agent and the hardening catalyst are reduced achieves the shear strength that is almost twice that of the related-art epoxy layer, and an area of the electrode region 110 at the bonding boundary is increased by reducing each of the hardening agent and the hardening catalyst to an amount about a half.

In this invention, a heat-hardening resin layer is provided between a wiring circuit and a thermoplastic resin layer, and a crosslinking degree in this heat-hardening resin layer is reduced by reducing a use amount of a hardening agent from a related-art amount. With such constitution, it is possible to prevent electrical short between a part directly under a semiconductor and a wiring pattern in the case where a high temperature and a high pressure are applied to a semiconductor mounting part.

## Claims

1. A method of producing a wiring board on which a semiconductor chip is to be mounted, the method comprising:
adhering an aluminum foil to one surface of a resin substrate;
providing a heat-hardening resin layer having a predetermined shape on the aluminum foil;
removing a part of the aluminum foil which is exposed from the heat-hardening resin layer to form a wiring circuit; and
providing a thermoplastic resin layer on the wiring circuit.

2. A method of mounting the semiconductor chip on the wiring board produced by the method according to claim 1, comprising:
applying heat to the wiring board;
pressing a bump of the semiconductor chip to the thermoplastic resin layer which is softened by the heat, while applying an ultrasonic wave to the bump;
causing the bump to be in contact with the wiring circuit;
applying the ultrasonic wave to the bump in a state where the bump and the wiring circuit are in contact with each other; and
adhering the semiconductor chip to the wiring board by cool-solidifying the thermoplastic resin layer,
wherein the heat-hardening resin layer has strength that enables the wiring board to prevent short between the semiconductor chip and the wiring circuit and has a crosslinking degree that is so reduced as to enable the bump to remove the heat-hardening resin layer to reach the wiring circuit, when the heat is applied to the wiring board and the bump to which the ultrasonic wave is applied is pressed to the wiring board.

3. The method according to claim 2, wherein the heat-hardening resin layer includes an epoxy-based resin to which a hardening agent such as amines, acid anhydrides and phenols, and a hardening catalyst such as amines.

4. A wiring board on which a semiconductor chip is to be mounted, the wiring board comprising:
a resin substrate;
a wiring circuit provided on one surface of the resin substrate;
a heat-hardening resin layer provided on the wiring circuit; and
a thermoplastic resin layer provided on the heat-hardening resin layer.

5. The wiring board according to claim 4, wherein
wherein the heat-hardening resin layer has strength that enables the wiring board to prevent short between the semiconductor chip and the wiring circuit and has a crosslinking degree that is so reduced as to enable a bump of the semiconductor chip to remove the heat-hardening resin layer to reach the wiring circuit, when heat is applied to the wiring board and the bump to which an ultrasonic wave is applied is pressed to the wiring board.

6. The wiring board according to claim 5, wherein the heat-hardening resin layer includes an epoxy-based resin to which a hardening agent such as amines, acid anhydrides and phenols, and a hardening catalyst such as amines.
